# EUROPÄISCHE PATENTSCHRIFT

(11) **EP 2 977 894 B1**
(45) Veröffentlichungstag und Bekanntmachung des Hinweises auf die Patenterteilung: **12.09.2018**
(21) Anmeldenummer: 14177800.1
(22) Anmeldetag: 21.07.2014
(51) Int. Cl.: G06F 8/41, G06F 17/50, G06F 11/26, G06F 11/36

(54) **Erstellen eines FPGA-Codes mit automatisch eingefügter Beeinflussungsstruktur**
Creating an FPGA code with automatically inserted influencing structure
Création d'un code FPGA ayant une structure d'influence automatiquement insérée

(43) Veröffentlichungstag der Anmeldung: 27.01.2016
(73) Patentinhaber: dSPACE digital signal processing and control engineering GmbH, 33102 Paderborn (DE)
(72) Erfinder: Kalte, Heiko, 33106 Paderborn (DE); Lubeley, Dominik, 33415 Verl (DE); Funke, Lukas, 33102 Paderborn (DE); Klahold, Jürgen, 33034 Brakel (DE)

(56) Entgegenhaltungen:
- US-A1- 2009 307 667
- US-A1- 2012 005 547
- US-B2- 7 458 042
- GRAHAM P ET AL: "Instrumenting Bitstreams for Debugging FPGA Circuits", FIELD-PROGRAMMABLE CUSTOM COMPUTING MACHINES, 2001. FCCM '01. THE 9TH ANNUAL IEEE SYMPOSIUM ON ROHNERT PARK, CA, USA 29-02 APRIL 2001, PISCATAWAY, NJ, USA,IEEE, 29. April 2001 (2001-04-29), Seiten 41-50, XP010789103, ISBN: 978-0-7695-2667-6
- LAGADEC L ET AL: "Software-like debugging methodology for reconfigurable platforms", PARALLEL&DISTRIBUTED PROCESSING, 2009. IPDPS 2009. IEEE INTERNATIONAL SYMPOSIUM ON, IEEE, PISCATAWAY, NJ, USA, 23. Mai 2009 (2009-05-23), Seiten 1-4, XP031487669, ISBN: 978-1-4244-3751-1
- Anonymous: "Field-programmable gate array - Wikipedia, the free encyclopedia", , 4 February 2013 (2013-02-04), XP055123299, Retrieved from the Internet: URL:http://en.wikipedia.org/w/index.php?ti tle=Field-programmable_gate_array&oldid=53 6512233 [retrieved on 2014-06-13]

## Beschreibung

Die vorliegende Erfindung betrifft ein Verfahren zur Prüfung der externen Verdrahtung bei FPGA-getriebenen Kanälen eines HiL-Simulators (HiL: Hardware-in-the-Loop), das Verfahren umfassend das Erstellen eines FPGA-Codes für ein FPGA-Modell, umfassend die Schritte Entwerfen des FPGA-Modells als FPGA-Programm mit wenigstens zwei Komponenten und wenigstens einem Signalpfad zwischen den wenigstens zwei Komponenten, Setzen einer Markierung in mindestens einem Signalpfad in dem FPGA-Programm, und Erzeugen des FPGA-Modells als FPGA-Code basierend auf zumindest einem Teil des Modells. Weiterhin betrifft die Erfindung eine Datenverarbeitungseinrichtung mit einer Prozessoreinheit, wobei die Datenverarbeitungseinrichtung zur Durchführung des obigen Verfahrens ausgeführt ist. Auch betrifft die Erfindung ein Computerprogrammprodukt mit Computer-implementierten Anweisungen, das nach dem Laden und Ausführen in einer geeigneten Datenverarbeitungseinrichtung die Schritte des obigen Verfahrens ausführt. Ferner betrifft die Erfindung ein digitales Speichermedium mit elektronisch auslesbaren Steuersignalen, die so mit einer programmierbaren Datenverarbeitungseinrichtung zusammenwirken können, dass das obige Verfahren auf der Datenverarbeitungseinrichtung ausgeführt wird.

In Fällen der Inbetriebnahme und des Debuggings von FPGAs ist es hilfreich, wenn man währen des Betriebs einzelne Signalpfade debuggen kann, d.h. Signalwerte auf dem Signalpfad auslesen und/oder verändern kann.

Um einen Signalwert eines Signalpfades im FPGA zur Laufzeit debuggen zu können, muss dies bereits bei der Modellierung berücksichtigt werden. Entsprechend muss ein passender Zugang vorbereitet werden, indem der Zugang in dem FPGA-Modell modelliert wird. Beispielsweise kann im Signalpfad ein Multiplexer angeordnet werden, mit dem zwischen dem Normalbetrieb, in dem ein Signalwert als Originalsignal auf dem Signalpfad anliegt und dieser Signalwert weder ausgelesen noch verändert werden kann, und einem Ersatzsignal umgeschaltet werden kann. Eine solche Modellierung ist aufwendig und erhöht die Komplexität des Modells, wodurch es unübersichtlich wird. Die Komplexität steigt mit der Anzahl der zu debuggenden Signalpfade, da eine entsprechende Modellierung für jedes gewünschte Signal bzw. für jeden gewünschten Signalpfad erforderlich ist. Wenn ein zusätzlicher Signalpfad debuggt werden soll, muss das FPGA-Modell angepasst werden. Auch ist die Erzeugung eines neuen FPGA-Codes ausgehend von dem geänderten FPGA-Modell erforderlich, was zeitaufwendig ist.

Aus der US 2012/005547 A1 ist ein Debugging System für Prototypen bekannt, welches von einem Host Prozessor über einen Bus gesteuert werden kann. In eine zu testende Logikschaltung werden ein oder mehrere eingebettete Debugging-Schaltkreise eingefügt, die Signale dieser Schaltung empfangen. Eine erste Gruppe von Signalen werden auf die Erfüllung von Trigger-Bedingungen überprüft, woraufhin eine zweite Gruppe von Signalen verändert wird. Die Auswahl der Signale erfolgt vorzugsweise mittels Multiplexern, die über Steuersignale von den eingebetteten Debugging-Schaltkreisen angesteuert werden. Die eingebetteten Debbuging-Schaltkreise umfassen eingebauten Speicher zum Speichern von Signalen und sind über lokale Debugging-Controller und einen Vector-Prozessor-Bus mit einem Vector-Prozessor verbunden, der Signale von und zu dem Host Prozessor überträgt. Das Debugging-System kann mehrere programmierbare Logikbausteine umfassen, auf denen jeweils Teile der zu testenden Logikschaltung und zugeordnete Debugging-Schaltkreise implementiert sind. Die zu testende Logikschaltung wird vorbereitet, indem eine Dummy-Schnittstelle für die eingebetteten Debugging-Schaltkreise eingefügt wird. Der Nutzer spezifiziert, welche Signale der zu testenden Logikschaltung mit welchem Kanal der Dummy-Schnittstelle verbunden werden, und definiert Trigger-Bedingungen. In einem automatisierten Prozess wird die zu testende Logikschaltung um die eingebetteten Debugging-Schaltkreise, die lokalen Debugging-Controller und den Vector-Prozessor-Bus ergänzt.

Die US 7,458,042 B2 offenbart eine Vorrichtung und ein Verfahren zum Debuggen von einer elektronischen Schaltung, die anhand eines ursprünglichen Programms in einer Hardwarebeschreibungssprache erstellt wird. Ein weiteres Programm definiert eine zusätzliche Schaltung, die über mindestens einen Ein- oder Ausgangsanschluss mit der elektronischen Schaltung verbunden und dazu geeignet ist, ein Signal von dem Ein- oder Ausgangsanschluss auf einen vorgegebenen Wert zu setzen. Ein modifiziertes Programm wird erstellt, das neben der ursprünglichen elektronischen Schaltung auch eine Beschreibung der zusätzlichen Schaltung in einer Hardwarebeschreibungssprache enthält. Das modifizierte Programm wird in einen FPGA geschrieben und ausgeführt, wobei zu einem vorgegebenen Zeitpunkt das ausgewählte Signal auf einen bestimmten Wert gesetzt wird, um die elektronische Schaltung zu Debuggen.

Ausgehend von dem oben genannten Stand der Technik liegt der Erfindung somit die Aufgabe zugrunde, ein Verfahren der oben genannten Art anzugeben, das eine einfache Erzeugung eines FPGA-Modells ermöglicht und ein Debuggen von basierend auf dem FPGA-Modell erstelltem FPGA-Code auf einfache und effiziente Weise ermöglicht.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zum Erstellen eines FPGA-Codes für ein FPGA-Modell vorgesehen, umfassend die Schritte Entwerfen des FPGA-Modells als FPGA-Programm mit wenigstens zwei Komponenten und wenigstens einem Signalpfad zwischen den wenigstens zwei Komponenten, Setzen einer Markierung in mindestens einem Signalpfad in dem FPGA-Programm, Erzeugen des FPGA-Modells als FPGA-Code basierend auf zumindest einem Teil des Modells, wobei der Schritt des Erzeugens des FPGA-Modells als FPGA-Code das automatische Einfügen einer Beeinflussungsstruktur in dem mit Markierung versehenen Signalpfad und das Erzeugen des FPGA-Modells mit der Beeinflussungsstruktur umfasst.

Erfindungsgemäß ist ferner eine Datenverarbeitungseinrichtung mit einer Prozessoreinheit angegeben, wobei die Datenverarbeitungseinrichtung zur Durchführung des obigen Verfahrens ausgeführt ist.

Erfindungsgemäß ist auch ein Computerprogrammprodukt mit Computer-implementierten Anweisungen, das nach dem Laden und Ausführen in einer geeigneten Datenverarbeitungseinrichtung die Schritte des obigen Verfahrens ausführt, angegeben.

Weiterhin ist erfindungsgemäß ein digitales Speichermedium mit elektronisch auslesbaren Steuersignalen angegeben, die so mit einer programmierbaren Datenverarbeitungseinrichtung zusammenwirken können, dass das obige Verfahren auf der Datenverarbeitungseinrichtung ausgeführt wird.

Grundidee der vorliegenden Erfindung ist es also, das Erzeugen eines FPGA-Codes dahingehend zu vereinfachen, dass das FPGA-Programm wie gewohnt erstellt werden kann, ohne dass zusätzliche Strukturen für Debug-Funktionen vom Anwender erstellt werden müssen. Für ein finales FPGA-Modell, welches ohne Debug-Funktionen übersetzt wird, sind somit keine Änderungen des FPGA-Programms als solchem erforderlich. Eine Übersetzung des FPGA-Programms zur Erzeugung des FPGA-Codes kann davon ausgehend erfolgen, indem lediglich das erzeugte FPGA-Programm übersetzt wird, und die Markierung des Signalpfads vernachlässigt wird. Entsprechend kann das automatische Einfügen einer Beeinflussungsstruktur in dem mit der Markierung versehenen Signalpfad einfach weggelassen werden. Dies vereinfacht die Erzeugung des FPGA-Programms dahingehend, dass keine zusätzlichen Strukturen für das Debuggen modelliert werden müssen. Da jede Modellierung bzw. Programmierung prinzipiell fehlerbehaftet sein kann, wird die Wahrscheinlichkeit für Fehler reduziert. Insbesondere die Wahrscheinlichkeit für Fehler, die lediglich Debug-Funktionen selber betreffen, können deutlich reduziert werden. Im Ergebnis kann das FPGA-Modell übersichtlich gehalten werden und eine Beeinflussung von Signalpfaden kann ohne zusätzlichen Modellierungsaufwand durchgeführt werden.

Ausgehend von dem Setzen der Markierung in dem Signalpfad kann zu einem beliebigen Zeitpunkt während der Ausführung des FPGA-Modells ein interner, markierter Signalpfad aufgebrochen werden, um den Signalwert auf dem Signalpfad vollständig zu ersetzen oder zu verändern. Der Nutzer setzt dazu nur Markierungen für die Signalpfade im FPGA-Modell, auf die er zur Laufzeit Zugriff haben möchte.

Als veränderter Signalwert können ein einfacher Wert oder Vektoren, d.h. Signale verschiedener Breite, verwendet werden. Auch können einzelne Werte oder ein zeitlicher Verlauf, beispielsweise in der Form von Wavetables, verwendet werden. Auch kann eine Funktionen aus dem ursprünglichen Signalwert und verstellbaren Parametern, z.B. eine Multiplikation des Signalwerts mit einem veränderlichen Faktor, oder eine Addition von Rauschen, als veränderter Signalwert verwendet werden.

Dies eröffnet eine Vielzahl von Anwendungsgebieten, im allgemeinen Fall das allgemeine Debuggen von internen FPGA-Komponenten zur Laufzeit. Ein weiteres Anwendungsgebiet im Umfeld von automotiven Hardware-in-the-Loop-Simulationen (HiL) ist die Stimulation von I/O-Kanälen für die Prüfung der externen Verdrahtung (Stimulus Tests) bei FPGA getriebenen I/O-Kanälen. In HiL-Umfeld werden FPGA-Modelle vor allem dort eingesetzt, wo schnelle Regelkreise geschlossen werden müssen, z.B. für sehr dynamische Teile eines Umgebungsmodells. Dies ist etwa bei der Simulation von Zylinderinnendrucksensoren der Fall, die bei der Verbrauchs- oder Abgasreduktion eine zunehmend größere Rolle spielen. Darüber hinaus lassen sich auch virtuelle Steuergeräte (virtuelle ECUs) über diese Mechanismen an die I/O-Kanäle anschließen, was eine Umschaltung zwischen einer realen und der virtuellen ECU ermöglicht.

Das automatische Einfügen einer Beeinflussungsstruktur in dem mit Markierung versehenen Signalpfad umfasst dabei das Einfügen aller FPGA-Beeinflussungskomponenten und/oder Pfade, die für die Beeinflussungsstruktur erforderlich sind. Details hierzu sind nachstehend angegeben. Die FPGA-Beeinflussungskomponenten und/oder Pfade der Beeinflussungsstruktur werden dabei automatisch im FPGA-Programm eingefügt, allerdings nicht im FPGA-Modell. Auf diese Weise entfallen Modellierungsaufwände im FPGA-Modell, die bei im Stand der Technik üblicher, manueller Programmierung der Beeinflussungsfunktion anfallen, und das FPGA-Modell bleibt übersichtlich.

Debug- und Experimentiermöglichkeiten, die bei Modellen die derzeit auf Prozessoren laufen, genutzt werden, können somit auf FPGAs übertragen werden, sodass die Handhabung von FPGA-Code und Code zur Ausführung auf einer CPU angeglichen werden kann. Damit wird einem Nutzer in Bezug auf die "Usability" möglichst viel von dem gewohnten Komfort geboten, den der Nutzer von Code zur Ausführung auf einer CPU kennt.

Die Datenverarbeitungseinrichtung kann prinzipiell beliebig ausgeführt sein. Die Datenverarbeitungseinrichtung kann mit einem entfernten Steuerungsrechner über eine Datenverbindung verbunden sein.

In vorteilhafter Ausgestaltung der Erfindung umfasst der Schritt des Setzens einer Markierung das Auswählen einer Komponente des FPGA-Programms und das automatische Setzen von Markierungen in allen Signalpfaden der Komponente. Dies ermöglicht auf einfach Weise eine Analyse des Verhaltens einer Komponente des FPGA-Programms, da alle Signalpfade zum Debuggen bereitgestellt werden können. Dazu kann die Komponente vorzugsweise in einer graphischen Entwicklungsumgebung auswählen, z.B. durch einen Mausklick und ein sich daraufhin an der Komponente öffnendes Auswahlmenü.

In vorteilhafter Ausgestaltung der Erfindung umfasst der Schritt des Setzens einer Markierung in mindestens einem Signalpfad in dem FPGA-Programm das graphische Auswählen eines Bereichs des FPGA-Programms in einem graphischen Entwicklerwerkzeug und das das automatische Setzen von Markierungen in allen Signalpfaden in dem Bereich der graphischen Auswahl. Über die graphische Auswahl können die Markierungen einfach gesetzt werden, beispielsweise können Markierungen in allen Signalpfaden gesetzt werden, die eine Grenze einer ausgewählten graphischen Form kreuzen, oder die sich ganz oder zumindest teilweise innerhalb einer ausgewählten graphischen Form befinden. Die Form kann prinzipiell beliebig gewählt werden, beispielsweise als eine beliebige geometrische Form.

In vorteilhafter Ausgestaltung der Erfindung umfasst das Verfahren vor dem Erzeugen des FPGA-Modells das Aktivieren/Deaktivieren der Markierung, und der Schritt des automatischen Einfügen einer Beeinflussungsstruktur in dem mit der Markierung versehenen Signalpfad umfasst das automatische Einfügen der Beeinflussungsstruktur für aktive Markierungen. Durch das Aktivieren/Deaktivieren der Markierung kann das FPGA-Modell auf einfache Weise angepasst werden, ohne dass prinzipielle Änderungen an dem FPGA-Modell erforderlich sind. Die Markierung kann beispielsweise einen Schalter aufweisen, der zwischen den Zuständen "aktiviert" und "deaktiviert" umschaltbar ist. Die Aktivierung der Markierung kann vorzugsweise für jede Markierung individuell erfolgen. Alternativ kann eine Aktivierung für eine Mehrzahl von Markierungen gemeinsam oder für alle Markierungen gemeinsam erfolgen. Auch Gruppen von Markierungen können gemeinsame aktiviert/deaktiviert werden. Eine aktivierte Markierung bewirkt, dass bei der Erstellung des FPGA-Codes in den FPGA-Code eine entsprechende Beeinflussungsstruktur in den markierten Signalpfad eingefügt wird, während eine deaktivierte Markierung bewirkt, dass der markierte Signalpfad unverändert gelassen wird.

In vorteilhafter Ausgestaltung der Erfindung umfasst das Verfahren vor dem Erzeugen des FPGA-Modells das Konfigurieren der Markierung, und der Schritt des automatischen Einfügens einer Beeinflussungsstruktur in dem mit Markierung versehenen Signalpfad das Einfügen der Beeinflussungsstruktur abhängig von Ihrer Konfigurierung umfasst. Das Konfigurieren kann somit auf einfache Weise durch den Nutzer erfolgen. Durch die einfache Implementierung über die Markierung kann das FPGA-Modell mit einer guten Übersichtlichkeit angelegt werden, wobei gleichzeitig ein hohes Maß an Debug-Funktionalität individuell bereitgestellt werden kann. Die Auswahl der Konfigurierung erfolgt vorzugsweise durch den Nutzer. Besonders bevorzugt ist eine Konfigurierung der Markierung bereits beim Setzen der Markierung als Voreinstellung gewählt, so dass nach dem Setzen der Markierung nur ein Konfigurieren der Markierung durch den Nutzer erforderlich ist, wenn eine alternative Konfigurierung gewünscht ist. Die Auswahl der Konfigurierung erfolgt vorzugsweise in einem Auswahlmenü. Besonders bevorzugt wird im FPGA-Modell, beispielsweise in einer Modellierungsumgebung, nur die gesetzte Markierung als solche angezeigt, nicht Ihre Konfiguration. Dadurch bleibt das FPGA-Modell übersichtlich.

In vorteilhafter Ausgestaltung der Erfindung umfasst der Schritt des automatischen Einfügens einer Beeinflussungsstruktur das Einfügen einer Beeinflussungsstruktur zur Bereitstellung eines alternativen Signalwertes in dem Signalpfad oder zur Verfälschung des Signalwertes in dem Signalpfad. Als Alternativwert kann beispielsweise ein konstanter oder ein variabler Signalwert in dem markierten Signalpfad bereitgestellt werden. Die Bereitstellung des Signalwertes kann entweder über eine Konstante, partielle Rekonfiguration des FPGA, einen I/O-Pin, einen Ausgabewert einer anderen, vorhandenen FPGA-Komponente, oder einen Ausgabewert einer als Teil der Beeinflussungsstruktur hinzugefügten Beeinflussungskomponente erfolgen. Die Wertverfälschung betrifft eine Veränderung eines in dem Signalpfad anliegenden Signalwertes.

In vorteilhafter Ausgestaltung der Erfindung umfasst der Schritt des automatischen Einfügens einer Beeinflussungsstruktur das Einfügen einer Beeinflussungsstruktur zum Auslesen eines Signalwertes in dem markierten Signalpfad. Das Auslesen des Signalwertes kann über an sich bekannte Verfahren erfolgen, beispielsweise über eine Readback-Funktionalität oder eine Verbindung des markierten Signalpfads mit einem I/O-Pin. Die Verbindung des markierten Signalpfads mit dem I/O-Pin erfolgt vorzugsweise direkt oder über einen Multiplexer.

Erfindungsgemäß umfasst der Schritt des automatischen Einfügens einer Beeinflussungsstruktur das Einfügen eines Multiplexers. Der Multiplexer kann zur Laufzeit umgeschaltet werden, um unterschiedliche am Multiplexer anliegende Eingangssignale auf dem markierten Signalpfad bereitzustellen. So kann beispielsweise eine Debugoption aktiviert werden, indem ein markierter Signalpfad über den Multiplexer aufgetrennt wird und ein gewünschter Signalwert auf dem markierten Signalpfad bereitgestellt wird, entweder als statischer Signalwert oder als dynamischer Signalwert. Der Multiplexer kann über partielle Rekonfiguration zwischen seinen Eingängen umgeschaltet werden. Besonders bevorzugt ist der markierte Signalpfad mit einem ersten Eingang und dem Ausgang des Multiplexers verbunden, so dass als Voreinstellung der markierte Signalpfad über den Multiplexer durchverbunden ist.

In vorteilhafter Ausgestaltung der Erfindung umfasst der Schritt des Einfügens eines Multiplexers das Einfügen eines Multiplexers mit Selektoreingang, wobei der Selektoreingang zur Laufzeit des FPGA-Codes beeinflussbar ist. Über den Selektoreingang des Multiplexers kann zur Laufzeit dynamisch umgeschaltet werden, welches am Multiplexer anliegende Eingangssignal auf dem markierten Signalpfad bereitgestellt wird. So kann beispielsweise zur Laufzeit eine Debugoption aktiviert werden, indem ein markierter Signalpfad über den Multiplexer aufgetrennt wird und ein gewünschter Signalwert auf dem markierten Signalpfad bereitgestellt wird, entweder als statischer Signalwert oder als dynamischer Signalwert. Bei einem Multiplexer mit zwei Eingängen kann am Selektoreingang ein binäres Signal ausreichen, um zwischen den beiden Eingängen umzuschalten. Bei einem Multiplexer mit mehr als zwei Eingängen kann am Selektoreingang einzelnes Signal zur Signalisierung des Eingangs oder eine Mehrzahl binärer Signale angelegt werden, um zwischen den Eingängen umzuschalten. Besonders bevorzugt ist der Multiplexer derart angeordnet, dass er den markierten Signalpfad über einen seiner Eingänge durchverbindet, wenn der entsprechende Eingang ausgewählt ist. Somit kann auf einfache Weise zwischen einem normalen Betriebsmodus, in dem der markierte Signalpfad über den Multiplexer durchverbunden ist, und einem Debugmodus, in dem in dem markierten Signalpfad ein gewünschter Signalwert bereitgestellt wird, umgeschaltet werden. Das Umschalten kann prinzipiell zur Laufzeit des FPGA-Programms auf dem FPGA erfolgen.

In vorteilhafter Ausgestaltung der Erfindung umfasst der Schritt des automatischen Einfügens einer Beeinflussungsstruktur das Einfügen einer Beeinflussungsstruktur mit einem zur Laufzeit beeinflussbaren Signalwert. Verschiedene Möglichkeiten der Ausgestaltung einer solchen Beeinflussungsstruktur sind möglich. Beispielsweise kann die Beeinflussungsstruktur eine Verbindung zu wenigstens einem I/O-Pin aufweisen, so dass über den wenigstens einen I/O-Pin eine dynamische Zuführung von Signalwerten ermöglicht wird, beispielsweise um eine Sequenz von Signalwerten auf dem markierten Signalpfad zu verwenden. Vorzugsweise ist die Beeinflussungsstruktur derart ausgeführt, dass über den I/O-Pin der Signalwert auf dem markierten Signalpfad ausgelesen werden kann. Somit kann eine Sequenz von Signalwerten über den I/O-Pin aufgezeichnet und zur Reproduktion über den I/O-Pin wieder auf dem markierten Signalpfad bereitgestellt werden. Auch kann die Beeinflussungsstruktur ein Speicherelement aufweisen oder mit einem solchen Speicherelement verbunden sein, um den Signalwert in dem markierten Signalpfad zur Laufzeit zu beeinflussen. Solche Speicherelemente können beispielsweise ein Register, eine Look-up Table (LUT) oder einen Multiplexer umfassen. Der Signalwert des Speicherelements kann vorzugsweise zur Laufzeit verändert werden, beispielsweise durch partielle Rekonfiguration. Durch einen Zugriff auf die Konfigurationsebene des FPGA können Daten zur Laufzeit in das FPGA übertragen werden. Die zur Laufzeit beeinflussbaren Signalwerte können alternativ über einen I/O-Eingang an das Speicherelement übertragen werden und stammen vorzugsweise aus einer Simulation, beispielsweise von einem virtuellem Steuergerät, oder können von einem Nutzer in einer beliebigen Weise vorgegeben werden, beispielsweise als Konstanten, zeitliche Abfolgen von Signalwerten, aufgezeichnete Signalwerte, o.ä.. Auch können die Signalwerte zur Laufzeit von einer anderen FPGA-Komponente, entweder einer existierenden Komponente oder einer zusätzlichen Beeinflussungskomponente, bereitgestellt werden.

In vorteilhafter Ausgestaltung der Erfindung umfasst der Schritt des Einfügens einer Beeinflussungsstruktur mit einem zur Laufzeit beeinflussbaren Signalwert das Einfügen einer FPGA-Beeinflussungskomponente und das Verbinden der eingefügten FPGA-Beeinflussungskomponente mit dem markierten Signalpfad. Das Einfügen der Beeinflussungsstruktur kann somit über das bloße substituieren von Signalwerten mit anderen, vorgegebenen Signalwerten hinausgehen. In der hinzugefügten FPGA-Beeinflussungskomponente kann beispielsweise eine Verarbeitung des jeweils aktuell auf dem markierten Signalpfad anliegenden Signalwerts erfolgen, so dass eine dynamische Änderung des Signalwerts erfolgen kann. Darüber kann eine gewünschte Wertverfälschung für den Signalpfad erreicht werden. Alternativ oder zusätzlich kann die hinzugefügte FPGA-Beeinflussungskomponente eine Eingabe/Ausgabe-Funktion realisieren, oder als Speicherkomponente ausgeführt sein. Auch kann die Beeinflussungsstruktur mehrere FPGA-Beeinflussungskomponenten gemeinsam aufweisen.

In vorteilhafter Ausgestaltung der Erfindung weist das Verfahren den zusätzlichen Schritt des Erzeugen des FPGA-Modells als FPGA-Code basierend auf zumindest einem Teil des Modells als Release auf, wobei der Schritt des Erzeugens des FPGA-Modells als FPGA-Code als Release das Erzeugen des FPGA-Modells ohne die Beeinflussungsstruktur umfasst. Somit kann die Beeinflussungsstruktur verwendet werden, um beispielsweise das Modell zu debuggen, wobei durch die Möglichkeit der Beeinflussung einzelner Signalpfade ein effizientes Debuggen möglich ist. Nach dem Debuggen kann ohne Veränderung des Modells eine Release-Version des FPGA-Modells erzeugt werden. Somit werden Fehler, die sich beim Entfernen von Codeteilen für das Debuggen ergeben können, zuverlässig vermieden.

Nachfolgend wird die Erfindung unter Bezugnahme auf die anliegende Zeichnung anhand bevorzugter Ausführungsformen näher erläutert.

Es zeigen
Fig. 1 ein Ablaufdiagramm eines Verfahrens zum Erstellen eines FPGA-Codes für ein FPGA-Modell gemäß einer ersten, bevorzugten Ausführungsform,
Fig. 2 eine schematische Ansicht eines beispielhaften FPGA-Modells, welches in einem Normalmodus erzeugt wurde,
Fig. 3 eine schematische Ansicht des FPGA-Modells aus Fig. 2, welches in einem Debugmodus erzeugt wurde, mit einem Testfokus,
Fig. 4 eine weitere schematische Ansicht eines weiteren, beispielhaften FPGA-Modells basierend auf dem FPGA-Modell aus Fig. 2, welches in einem Debugmodus erzeugt wurde, mit einer alternativen Konfigurierung,
Fig. 5 eine schematische Detailansicht eines weiteren, beispielhaften FPGA-Modells basierend auf dem FPGA-Modell aus Fig. 2, welches in einem Debugmodus erzeugt wurde, mit einer weiteren alternativen Konfigurierung,
Fig. 6 eine schematische Ansicht eines FPGA-Modells, welches in einem Debugmodus erzeugt wurde, in Verbindung mit einer Testumgebung zur Durchführung von eines Stimulus Tests, und
Fig. 7 eine schematische Ansicht eines FPGA-Modells, welches in einem Debugmodus erzeugt wurde, in Verbindung mit einer Testumgebung zum Umschalten zwischen einem virtuellen Steuergerät und einem realen Steuergerät.

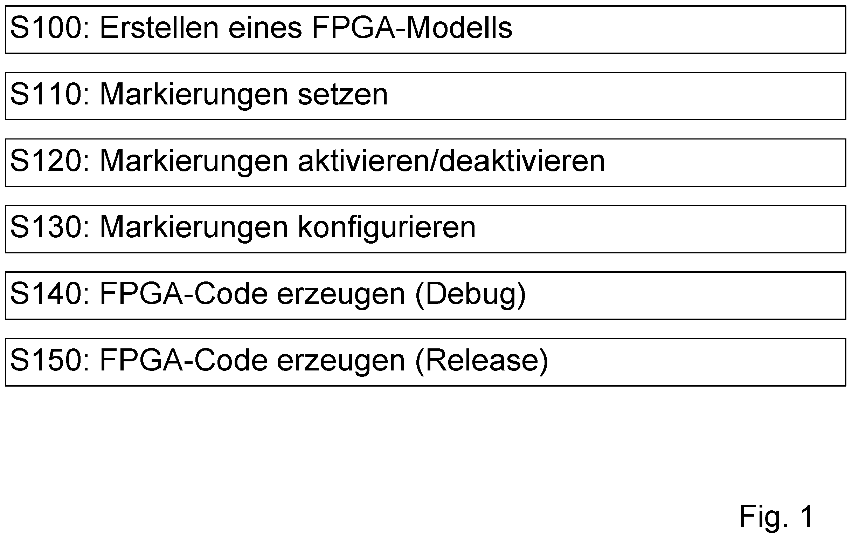

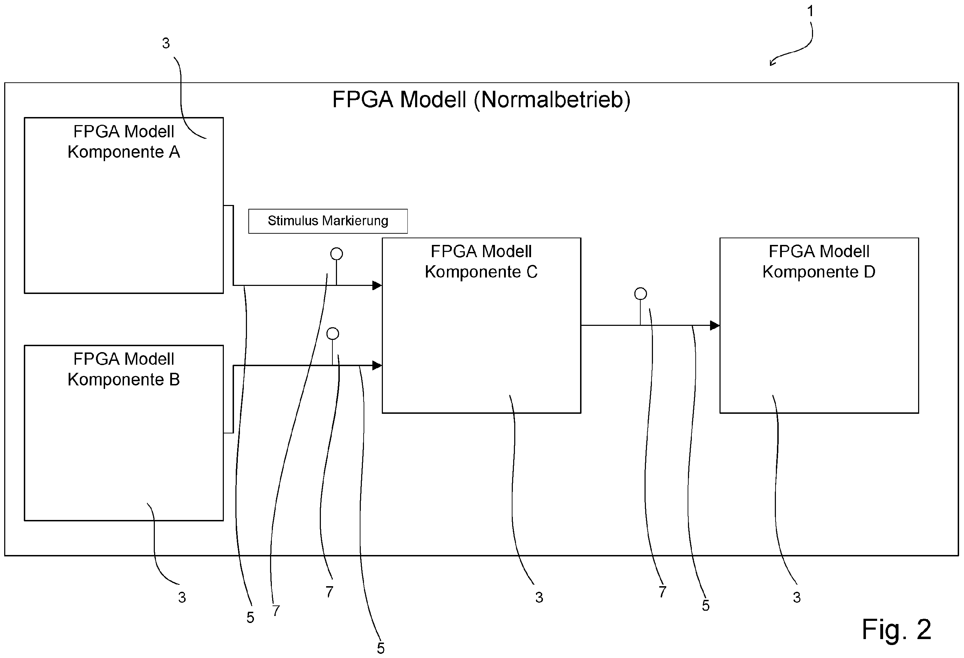

Die Figur 1 zeigt ein Ablaufdiagramm eines erfindungsgemäßen Verfahrens zum Erstellen eines FPGA-Codes für ein FPGA-Modell 1. Ein solches, sehr einfaches FPGA-Modell 1 ist in den Figuren 2 bis 4 für unterschiedliche Konfigurierungen dargestellt.

Das erfindungsgemäße Verfahren beginnt mit Schritt S100, in dem das FPGA-Modell 1 als FPGA-Programm von einem Nutzer entworfen wird. Das beispielhafte FPGA-Modell 1 umfasst hier eine Mehrzahl Komponenten 3, die hier mit den Buchstaben "A", "B", "C", "D" unterschieden werden. Das FPGA-Modell 1 umfasst weiterhin eine Mehrzahl Signalpfade 5, die zwischen den Komponenten 3 angeordnet sind.

In einem Schritt S110 wird hier in gewünschten Signalpfaden 5 eine Markierung 7 gesetzt, wie in Fig. 2 gezeigt ist. In dem vorliegenden Ausführungsbeispiel ist die Markierung 7 in jeden Signalpfad 5 gesetzt. Dazu wird in diesem Ausführungsbeispiel die mit dem Buchstaben "C" gekennzeichnete Komponente 3 ausgewählt, und in allen Signalpfaden 5 der Komponente 3 werden automatisch Markierungen 7 gesetzt. Alternativ können Markierungen auf individuell ausgewählten Signalpfaden einzeln gesetzt werden. Markierungen können auf verschiedene Arten realisiert und visualisiert werden. Markierungen können beispielsweise Attribute von Signalen sein. Eine Visualisierung kann beispielsweise über eine geometrische oder farbliche Hervorhebung der Signalleitung erfolgen. Eine Visualisierung ist prinzipiell nicht notwendig, erleichtert jedoch das Auffinden der markierten Signale.

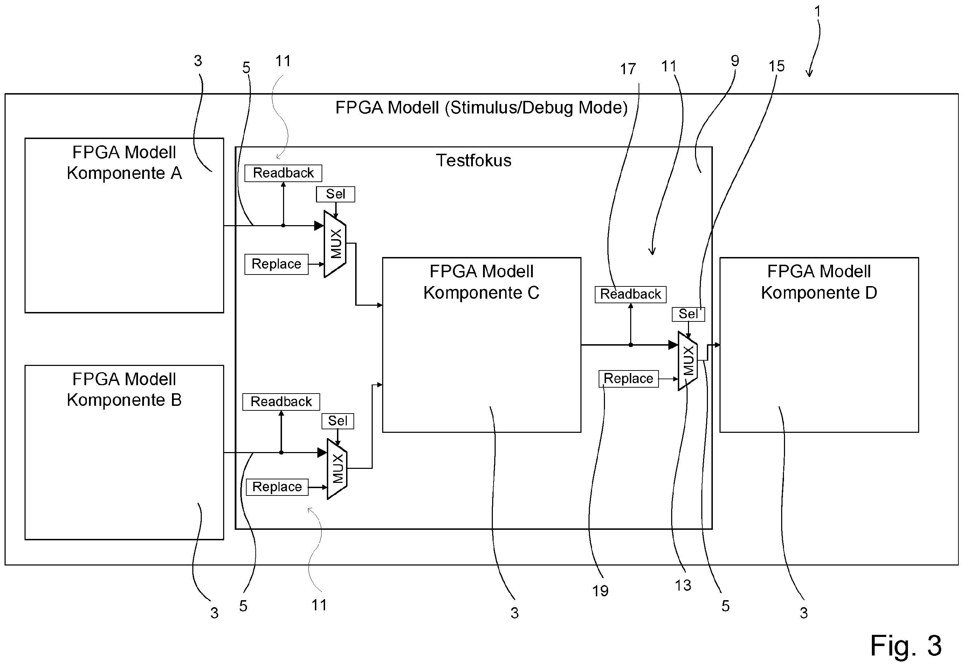

In einer alternativen Ausführungsform, die unter Bezug auf Fig. 3 erläutert wird, wird graphisch ein Bereich 9 ausgewählt und als Testfokus gesetzt. Entsprechend wird für alle Signalpfade 5, die zumindest teilweise in dem Bereich 9 liegen, eine Markierung 7 gesetzt. Das graphische Auswählen des Bereichs 9 des FPGA-Programms erfolgt in einem nicht dargestellten graphischen Entwicklerwerkzeug.

In einem Schritt S120 werden die Markierungen 7 aktiviert/deaktiviert. Entsprechend weisen die Markierungen 7 in diesem Ausführungsbeispiel jeweils einen Schalter auf, der individuell zwischen den Zuständen "aktiviert" und "deaktiviert" umschaltbar ist. Ein Nutzer aktiviert/deaktiviert die Markierungen 7 manuell in dem graphischen Entwicklerwerkzeug.

In einem Schritt S130 erfolgt ein Konfigurieren der Markierungen 7. Ein Nutzer konfiguriert die Markierungen 7 manuell in dem graphischen Entwicklerwerkzeug, wobei eine Konfigurierung für alle Markierungen 7 als Voreinstellung gewählt ist. Die Voreinstellung kann nach dem Setzen der Markierung 7 durch den Nutzer in beliebiger Weise geändert werden, wozu der Nutzer die Konfigurierung in einem Auswahlmenü auswählt. Im FPGA-Modell 1 wird dabei nur die gesetzte Markierung 7 als solche angezeigt, nicht Ihre Konfigurierung, wie in Fig. 2 ersichtlich.

In einem Schritt S140 wird das FPGA-Modell 1 als FPGA-Code basierend auf zumindest einem Teil des Modells als Debug-Version erzeugt. Dabei werden an den aktiven Markierungen 9 in dem mit der jeweiligen Markierung 7 versehenen Signalpfad 5 Beeinflussungsstrukturen 11 in dem FPGA-Code eingefügt und das FPGA-Modell 1 mit den Beeinflussungsstrukturen 11 erzeugt. Für deaktivierte Markierungen 7 wird der jeweilige Signalpfad 5 mit der gesetzten Markierung 7 unverändert gelassen. Dabei werden die Beeinflussungsstrukturen in dem jeweiligen mit der Markierung 7 versehenen Signalpfad 5 abhängig von der Konfigurierung der Markierung 7 eingefügt. Abhängig von der Konfigurierung wird eine Beeinflussungsstruktur 11 zur Bereitstellung eines alternativen Signalwertes in dem Signalpfad 5, zur Verfälschung des Signalwertes in dem Signalpfad 5, oder zum Auslesen eines Signalwertes in dem markierten Signalpfad 5 eingefügt.

Die Beeinflussungsstrukturen 11 können entsprechend gemäß einer ersten Konfigurierung, wie in dem Ausführungsbeispiel in Fig. 3 gezeigt, ausgestaltet sein. Entsprechend weisen die Beeinflussungsstrukturen 11 jeweils einen Multiplexer 13, hier als MUX bezeichnet, auf. Dabei ist der markierte Signalpfad 5 mit einem ersten Eingang 30 und einem Ausgang 34 des Multiplexers 13 verbunden, so dass als Voreinstellung der markierte Signalpfad 5 über den Multiplexer 13 durchverbunden ist. Ein zweiter Eingang 32 des Multiplexers 13 ist mit einem alternativen Signalwert verbunden, wie nachstehend erläutert. Der Multiplexer 13 weist weiterhin einen Selektoreingang 15, hier als Sel bezeichnet, auf, wobei der Selektoreingang 15 zur Laufzeit des FPGA-Codes beeinflussbar ist. Über den Selektoreingang 15 des Multiplexers 13 kann zur Laufzeit dynamisch umgeschaltet werden, welches am Multiplexer 13 anliegende Eingangssignal auf dem markierten Signalpfad 5 bereitgestellt wird, d.h. ob der erste Eingang 30 oder der zweite Eingang 32 des Multiplexers 13 mit dessen Ausgang 34 verbunden wird.

Zusätzlich umfassen die Beeinflussungsstrukturen 11 für die unter Bezug auf die Fig. 3 beschrieben Konfigurierung jeweils eine als Readback 17 gekennzeichnete Beeinflussungskomponente, welche über eine Readback-Funktion ein Auslesen des Signalwertes des Signalpfads 5 mit der jeweiligen Markierung 7 ermöglicht. In einer alternativen Ausgestaltung ist die als Readback 17 gekennzeichnete Beeinflussungskomponente zum Auslesen des Signalwertes des Signalpfads 5 mit der jeweiligen Markierung 7 ausgeführt, eine Verbindung des markierten Signalpfads 5 mit einem I/O-Pin herzustellen. Die Verbindung des markierten Signalpfads 5 mit dem I/O-Pin erfolgt direkt oder über einen Multiplexer.

Auch umfassen die Beeinflussungsstrukturen 11 für die unter Bezug auf die Fig. 3 beschrieben Konfigurierung jeweils eine als Replace 19 gekennzeichnete Beeinflussungskomponente, durch die ein konstanter oder ein variabler Signalwert in dem markierten Signalpfad 5 als alternativer Signalwert bereitgestellt wird. Die als Replace 19 gekennzeichnete Beeinflussungskomponente ist mit dem zweiten Eingang 32 des Multiplexers 13 verbunden. Die Bereitstellung des alternativen Signalwertes kann entweder über eine Konstante, partielle Rekonfiguration des FPGA, eine Verbindung zu einem I/O-Pin, oder einen Ausgabewert einer anderen FPGA-Komponente 3 oder einer nachfolgend beschriebenen Verfälschungskomponente 21, hier als Function bezeichnet, als Beeinflussungskomponente erfolgen. Dazu kann die Beeinflussungsstruktur 11 ein Speicherelement, beispielsweise ein Register, eine Look-up Table (LUT) oder einen Multiplexer aufweisen oder mit einem solchen Speicherelement verbunden sein, um den Signalwert in dem markierten Signalpfad 5 zur Laufzeit zu beeinflussen.

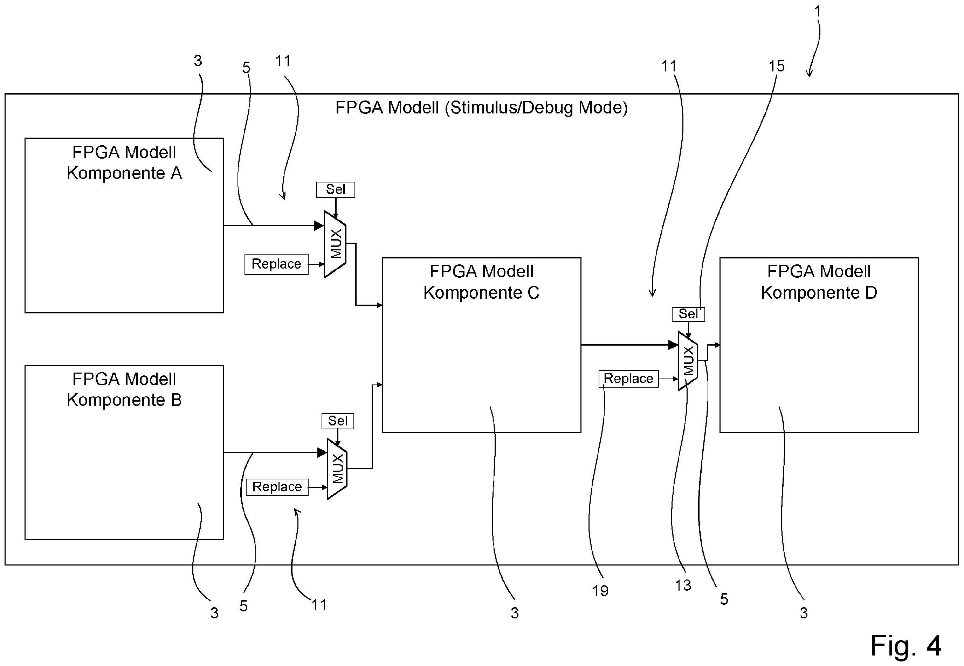

Das FPGA-Modell 1 gemäß einer alternativen Konfigurierung der Markierungen 7 ist in Fig. 4 dargestellt. In der Beeinflussungsstruktur 11 dieser Konfigurierung, die weitgehend mit der ersten Konfigurierung übereinstimmt, fehlt gegenüber der ersten Konfigurierung die als Readback 17 gekennzeichnete Beeinflussungskomponente. Im Übrigen stimmen die Beeinflussungsstrukturen 11 überein.

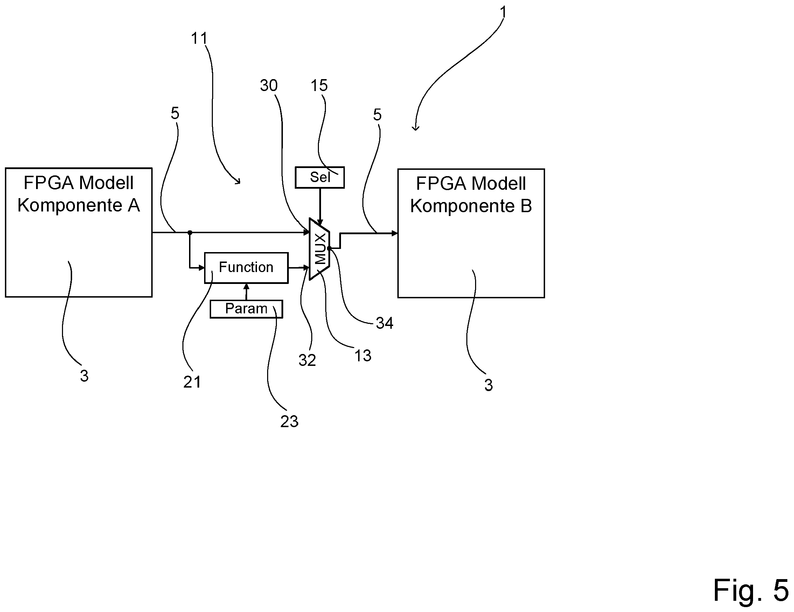

Das FPGA-Modell 1 gemäß einer alternativen Konfigurierung der Markierungen 7 ist in Fig. 5 in einer Detailansicht dargestellt. Gemäß dieser Konfigurierung weist die Beeinflussungsstruktur 11 eine Verfälschungskomponente 21 als Beeinflussungskomponente auf. Die Verfälschungskomponente 21 führt unter Verwendung eines Parameters 23, hier als Param bezeichent, eine Veränderung eines in dem markierten Signalpfad 5 anliegenden Signalwertes durch, und stellt diesen verfälschten Signalwert an dem Multiplexer 13 bereit. Entsprechend der vorbeschriebenen Ausgestaltung der Beeinflussungsstruktur 11 können somit zur Laufzeit beeinflussbare Signalwerte in dem markierten Signalpfad 5 bereitgestellt werden.

In einem Schritt S150 erfolgt das Erzeugen des FPGA-Modells 1 als FPGA-Code basierend auf zumindest einem Teil des Modells als Release. Entsprechend wird der FPGA-Code zu dem FPGA-Modell 1 ohne die Beeinflussungsstrukturen 11 erzeugt. Die Erzeugung des FPGA-Modells 1 als FPGA-Code basierend auf zumindest einem Teil des Modells als Release erfolgt ohne Änderungen des FPGA-Programms.

Das vorbeschriebene Verfahren eröffnet eine Vielzahl von Anwendungsgebieten. Als allgemeiner Fall ist das allgemeine Debuggen von internen FPGA-Komponenten 3 zur Laufzeit zu nennen, wie es beispielsweise mit den allgemeinen FPGA-Modellen und den Konfigurierungen der Figuren 3 bis 5 erfolgen kann. Dazu wird zur Laufzeit des FPGA-Modells 1 eine Debugoption aktiviert, indem die markierten Signalpfade 5 über die Multiplexer 13 aufgetrennt und gewünschte Signalwerte auf den markierten Signalpfaden 5 bereitgestellt werden. Das Auftrennen erfolgt somit über den Selektoreingang 15, über den zwischen dem ersten Eingang 30 und dem zweiten Eingang 32 des jeweiligen Multiplexers 13, die in Fig. 5 dargestellt sind, umgeschaltet werden kann. Dies ermöglicht eine interne Simulation von Fehlerfällen durch Austausch oder Verfälschung des ursprünglich auf dem Signalpfad 5 anliegenden Signalwerts. Bei der Verfälschung des ursprünglich auf dem Signalpfad 5 anliegenden Signalwerts über die Verfälschungskomponente 21 als Beeinflussungskomponente mit dem Parameter 23 verfälscht, um z.B. Offset- und Gain-Fehler oder Rauschen eines Inputs zu simulieren und damit die Stabilität eines FPGA Regelkreises in dem FPGA-Modell 1 zu testen.

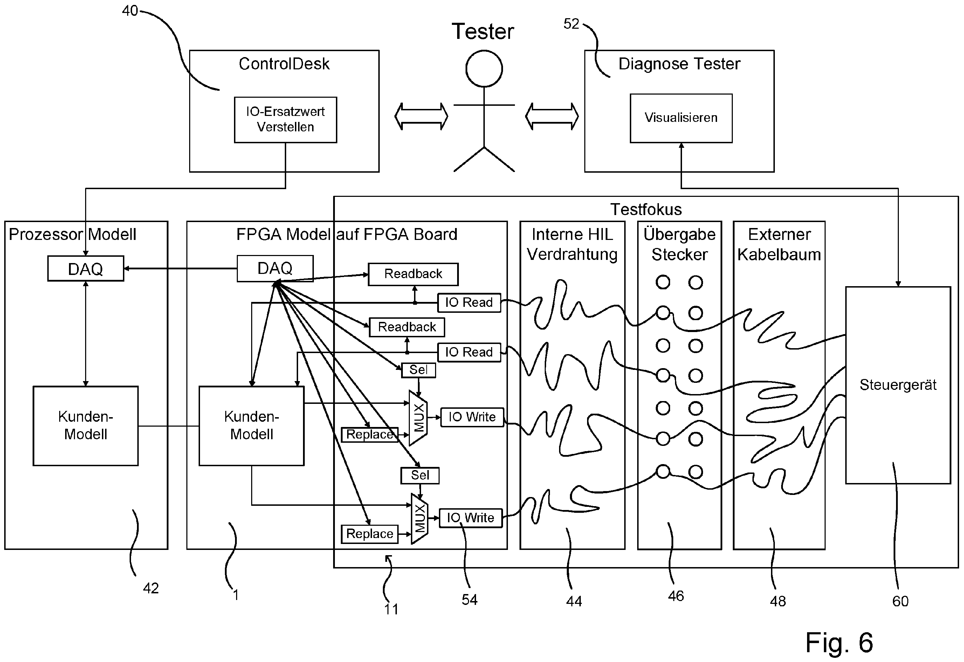

Ein weiteres Anwendungsgebiet im Umfeld von automotiven Hardware-in-the-Loop-Simulationen (HiL) ist die Stimulation von I/O-Kanälen für die Prüfung der externen Verdrahtung (Stimulus Tests) bei FPGA getriebenen I/O-Kanälen, wie in Fig. 6 dargestellt. Entsprechend ist ein Entwicklerwerkzeug 40, welches hier als ControlDesk der Fa. dSPACE ausgebildet ist, mit einem Prozessormodell 42 und darüber mit dem FPGA-Modell 1 verbunden. Angeschlossen an das FPGA-Modell 1 ist eine interne HiL-Verdrahtung 44, die die Verbindung zu einem Übergabestecker 46 realisiert. Es folgt eine Verbindung mit einem externen Kabelbaum 48 bis zu einem Steuergerät 60. Das Steuergerät 60 ist über einen nicht dargestellten Diagnosestecker mit einem Diagnosetester 52 verbunden. Mit diesem Aufbau können automatisierte Inbetriebnahmetests, Peripherietest oder auch HiL Stimulus Tests durchgeführt werden. Im FPGA-Modell 1 können über die Beeinflussungsstrukturen 11 statt der originalen Signalwerte an I/O-Ports 54 des FPGA feste Werte für die FPGA I/O-Signale vorgegeben werden, d.h. am modellseitigen Eingang der I/O-Ports 54 für einen Ausgangswert, zum Beispiel einen analogen Ausgangswert, der Signalwert durch einen Stimulus-Ersatzwert ersetzt werden kann. Somit kann der vollständige Weg von den I/O-Ports 54 bis zu dem Diagnosetester 52 auf Korrektheit der Signalverbindung getestet werden.

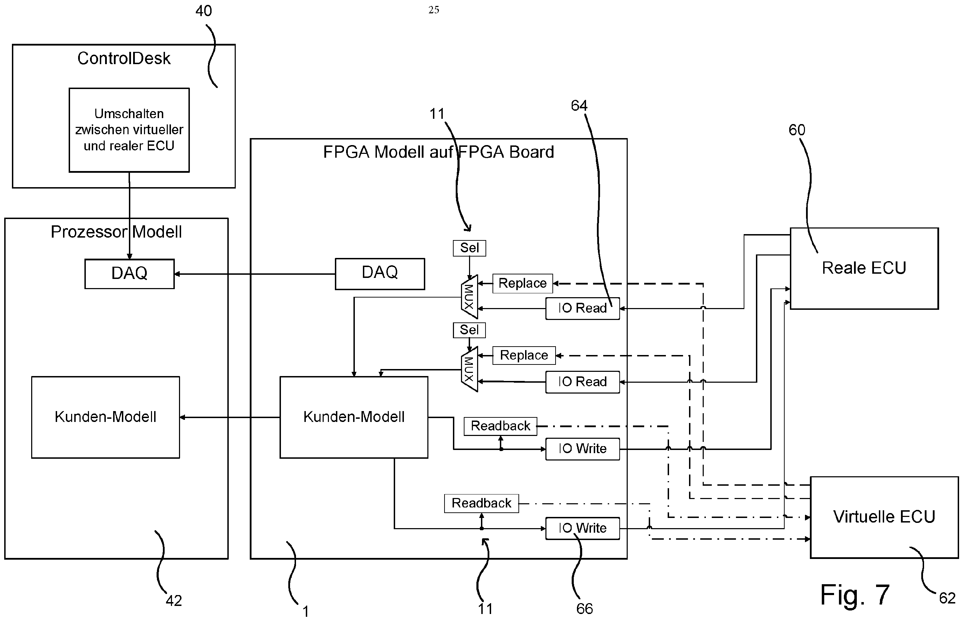

Ein weiteres Anwendungsbeispiel betrifft ein Umschalten zwischen einer Verbindung mit einer realen und einer virtuellen Steuerungseinheit (ECU) 60, 62, wie unter Bezug auf Fig. 7 beschrieben ist. Entsprechend ist auch hier das Entwicklerwerkzeug 40 ist mit einem Prozessormodell 42 und darüber mit dem FPGA-Modell 1 verbunden. Angeschlossen an das FPGA-Modell 1 sind die reale ECU 60 und die virtuelle ECU 62. Hier sind Eingabe-Kanäle 64 und Ausgabe-Kanäle 66 getrennt ausgeführt. Über die Beeinflussungsstrukturen 11 kann jeweils für die Eingabe-Kanäle 64 und die Ausgabe-Kanäle 66 zwischen der Verbindung zu der realen ECU 60 und der virtuellen ECU 62 umgeschaltet werden. Damit kann beispielsweise die virtuelle ECU 62 beispielsweise auf dem gleichen Rechenknoten gerechnet werden wie das Umgebungsmodell. Wenn die Beeinflussungsstrukturen 11 mit allen Eingabe-Kanälen 64 und Ausgabe-Kanälen 66 sowohl im FPGA-Modell 1, als auch im CPU-Modell 42 verbunden sind, kann an Umgebungsmodelle im Nachhinein ohne Rekompilierung eine virtuelle ECU angeschlossen werden. Dazu erfolgt ein synchrones Umschalten aller Multiplexer 13 im Betrieb zwischen virtueller ECU 60 und realer ECU 62.

**Bezugszeichenliste**

| | |
|---|---|
| FPGA-Modell | 1 |
| Komponente | 3 |
| Signalpfad | 5 |
| Markierung | 7 |
| Bereich/Testfokus | 9 |
| Beeinflussungsstruktur | 11 |
| Multiplexer | 13 |
| Selektoreingang | 15 |
| Readback, Beeinflussungskomponente | 17 |
| Replace, Beeinflussungskomponente | 19 |
| Verfälschungskomponente, Beeinflussungskomponente | 21 |
| Parameter | 23 |
| erster Eingang | 30 |
| zweiter Eingang | 32 |
| Ausgang | 34 |
| Entwicklerwerkzeug | 40 |
| Prozessormodell | 42 |
| interne HiL-Verdrahtung | 44 |
| Übergabestecker | 46 |
| externer Kabelbaum | 48 |
| Diagnosetester | 52 |
| I/O-Port | 54 |
| reale ECU | 60 |
| virtuelle ECU | 62 |
| Eingabe-Kanal | 64 |
| Ausgabe-Kanal | 66 |

## Patentansprüche

1. Verfahren zur Prüfung der externen Verdrahtung bei FPGA-getriebenen I/O-Kanälen eines HiL-Simulators, wobei ein Entwicklerwerkzeug (40) mit einem Prozessormodell (42) und darüber mit einem FPGA-Modell (1) verbunden ist, wobei an das FPGA-Modell (1) über I/O-Ports (54) des FPGA eine interne HiL-Verdrahtung (44) angeschlossen ist, die die Verbindung zu einem Übergabestecker (46) realisiert, woraufhin eine Verbindung mit einem externen Kabelbaum (48) bis zu einem Steuergerät (60) folgt, wobei das Steuergeräte (60) über einen Diagnosestecker mit einem Diagnosetester (52) verbunden ist,
das Verfahren umfassend das Erstellen eines FPGA-Codes für das FPGA-Modell (1), das Erstellen eines FPGA-Codes umfassend die Schritte
Entwerfen des FPGA-Modells (1) als FPGA-Programm mit wenigstens zwei Komponenten (3) und wenigstens einem Signalpfad (5) zwischen den wenigstens zwei Komponenten (3),
Setzen einer Markierung (7) in mindestens einem Signalpfad (5) in dem FPGA-Programm, und Erzeugen des FPGA-Modells (1) als FPGA-Code basierend auf zumindest einem Teil des Modells, wobei der Schritt des Erzeugens des FPGA-Modells (1) als FPGA-Code das automatische Einfügen einer Beeinflussungsstruktur (11), welche Signalwerte auf dem Signalpfad auslesen und/oder verändern kann, in dem mit einer Markierung (7) versehenen Signalpfad (5) und das Erzeugen des FPGA-Modells (1) mit der Beeinflussungsstruktur (11) umfasst, wobei der Schritt des automatischen Einfügens einer Beeinflussungsstruktur (11) das Einfügen eines Multiplexers (13) umfasst, der zur Laufzeit umgeschaltet werden kann, um unterschiedliche am Multiplexer anliegende Eingangssignale auf dem markierten Signalpfad bereitzustellen,
das Verfahren ferner umfassend das Vorgeben von festen Werten für die am I/O-Port (54) eines FPGA-getriebenen I/O-Kanals anliegenden Signale über die Beeinflussungsstrukturen (11) im FPGA-Modell (1) und das Prüfen der Korrektheit der Signalverbindung bis zu dem Diagnosetester (52).

2. Verfahren nach Anspruch 1, **dadurch gekennzeichnet, dass**
der Schritt des Setzens einer Markierung (7) in mindestens einem Signalpfad (5) in dem FPGA-Programm das Auswählen einer Komponente (3) des FPGA-Programms und das automatische Setzen von Markierungen (7) in allen Signalpfaden (5) der Komponente (3) umfasst.

3. Verfahren nach einem der Ansprüche 1 oder 2, **dadurch gekennzeichnet, dass**
der Schritt des Setzens einer Markierung (7) in mindestens einem Signalpfad (5) in dem FPGA-Programm das graphische Auswählen eines Bereichs (9) des FPGA-Programms in einem graphischen Entwicklerwerkzeug und das automatische Setzen von Markierungen (7) in allen Signalpfaden (5) in dem Bereich (9) der graphischen Auswahl umfasst.

4. Verfahren nach einem der vorhergehenden Ansprüche, **dadurch gekennzeichnet, dass** das Verfahren vor dem Erzeugen des FPGA-Modells (1) das Aktivieren/Deaktivieren der Markierung (7) umfasst, und der Schritt des automatischen Einfügens einer Beeinflussungsstruktur (11) in dem mit der Markierung (7) versehenen Signalpfad (5) das automatische Einfügen der Beeinflussungsstruktur (11) für aktive Markierungen (7) umfasst.

5. Verfahren nach einem der vorhergehenden Ansprüche, **dadurch gekennzeichnet, dass** das Verfahren vor dem Erzeugen des FPGA-Modells (1) das Konfigurieren der Markierung (7) umfasst, und
der Schritt des automatischen Einfügens einer Beeinflussungsstruktur (11) in dem mit Markierung (7) versehenen Signalpfad (5) das Einfügen der Beeinflussungsstruktur (11) abhängig von Ihrer Konfigurierung umfasst.

6. Verfahren nach einem der vorhergehenden Ansprüche, **dadurch gekennzeichnet, dass** der Schritt des automatischen Einfügens einer Beeinflussungsstruktur (11) das Einfügen einer Beeinflussungsstruktur (11) zur Bereitstellung eines alternativen Signalwertes in dem Signalpfad (5) oder zur Verfälschung des Signalwertes in dem Signalpfad (5) umfasst.

7. Verfahren nach einem der vorhergehenden Ansprüche, **dadurch gekennzeichnet, dass** der Schritt des automatischen Einfügens einer Beeinflussungsstruktur (11) das Einfügen einer Beeinflussungsstruktur (11) zum Auslesen eines Signalwertes in dem markierten Signalpfad (5) umfasst.

8. Verfahren nach einem der vorhergehenden Ansprüche, **dadurch gekennzeichnet, dass** der Schritt des Einfügens eines Multiplexers (13) das Einfügen eines Multiplexers (13) mit Selektoreingang (15) umfasst, wobei der Selektoreingang (15) zur Laufzeit des FPGA-Codes beeinflussbar ist.

9. Verfahren nach einem der vorhergehenden Ansprüche, **dadurch gekennzeichnet, dass** der Schritt des automatischen Einfügens einer Beeinflussungsstruktur (11) das Einfügen einer Beeinflussungsstruktur (11) mit einem zur Laufzeit beeinflussbaren Signalwert umfasst.

10. Verfahren nach dem vorhergehenden Anspruch 9, **dadurch gekennzeichnet, dass** der Schritt des Einfügens einer Beeinflussungsstruktur (11) mit einem zur Laufzeit beeinflussbaren Signalwert das Einfügen einer FPGA-Beeinflussungskomponente (17, 19, 21) und das Verbinden der eingefügten FPGA-Beeinflussungskomponente (17, 19, 21) mit dem markierten Signalpfad (5) umfasst.

11. Verfahren nach einem der vorhergehenden Ansprüche, **dadurch gekennzeichnet, dass** das Verfahren den zusätzlichen Schritt des Erzeugens des FPGA-Modells (1) als FPGA-Code, basierend auf zumindest einem Teil des Modells als Release aufweist,
wobei der Schritt des Erzeugens des FPGA-Modells (1) als FPGA-Code als Release das Erzeugen des FPGA-Modells ohne die Beeinflussungsstruktur (11) umfasst.

12. Datenverarbeitungseinrichtung mit einer Prozessoreinheit, wobei die Datenverarbeitungseinrichtung zur Durchführung des Verfahrens nach einem der Ansprüche 1 bis 11 ausgeführt ist.

13. Computerprogrammprodukt mit Computer-implementierten Anweisungen, das nach dem Laden und Ausführen in einer geeigneten Datenverarbeitungseinrichtung die Schritte des Verfahrens nach einem der Ansprüche 1 bis 11 ausführt.

14. Digitales Speichermedium mit elektronisch auslesbaren Steuersignalen, die so mit einer programmierbaren Datenverarbeitungseinrichtung zusammenwirken können, dass das Verfahren nach einem der Ansprüche 1 bis 11 auf der Datenverarbeitungseinrichtung ausgeführt wird.

## Claims

1. A method for testing the external wiring of FPGA-driven I/O channels of an HiL simulator, a developer tool (40) being connected to a processor model (42) and by means thereof to an FPGA model (1), an internal HiL wiring (44) being connected to the FPGA model (1) by means of I/O ports (54), said wiring implementing the connection to a transfer plug (46), resulting in a connection to an external cable harness (48) and to a control device (60), the control device (60) being connected to a diagnostic tester (52) by means of a diagnostic plug,
the method comprising creating an FPGA code for the FPGA model (1), and the creating of an FPGA code comprising the steps:
Drafting the FPGA model (1) as an FPGA program having at least two components (3) and at least one signal path (5) between the at least two components (3),
Setting a marker (7) in at least one signal path (5) in the FPGA program and generating the FPGA model (1) as FPGA code based on at least one part of the model, the step of generating the FPGA model (1) as FPGA code comprising automatically inserting an influencing structure (11) for reading out and/or modifying signal values on the signal path in the signal path (5) having a marker (7) and generating the FPGA model (1) having the influencing structure (11), the step of automatically inserting an influencing structure (11) comprising inserting a multiplexer (13) for being switched over during runtime for providing different input signals present at the multiplexer on the marked signal path,
the method further comprising specifying fixed values for the signals present at the I/O port (54) of an FPGA-driven I/O channel by means of the influencing structures (11) in the FPGA model (1) and testing the correctness of the signal connection up to the diagnostic tester (52).

2. The method according to claim 1, **characterized in that** the step of setting a marker (7) in at least one signal path (5) in the FPGA program comprises selecting a component (3) of the FPGA program and automatically setting markers (7) in all signal paths (5) of the component (3).

3. The method according to any one of the claims 1 or 2, **characterized in that**
the step of setting a marker (7) in at least one signal path (5) in the FPGA program comprises graphically selecting a range (9) of the FPGA program in a graphic developer tool and automatically setting markers (7) in all signal paths (5) in the range (9) of the graphic selection.

4. The method according to any one of the preceding claims, **characterized in that** the method comprises activating/deactivating the marker (7) prior to generating the FPGA model (1), and the step of automatically inserting an influencing structure (11) in the signal path (5) having the marker (7) comprises automatically inserting the influencing structure (11) for active markers (7).

5. The method according to any one of the preceding claims, **characterized in that** the method comprises configuring the marker (7) prior to generating the FPGA model (1), and
the step of automatically inserting an influencing structure (11) in the signal path (5) having the marker (7) comprises inserting the influencing structure (11) based on the configuring thereof.

6. The method according to any one of the preceding claims, **characterized in that** the step of automatically inserting an influencing structure (11) comprises inserting an influencing structure (11) for providing an alternative signal value in the signal path (5) or for falsifying the signal value in the signal path (5).

7. The method according to any one of the preceding claims, **characterized in that** the step of automatically inserting an influencing structure (11) comprises inserting an influencing structure (11) for reading out a signal value in the marked signal path (5).

8. The method according to any one of the preceding claims, **characterized in that** the step of inserting a multiplexer (13) comprises inserting a multiplexer (13) having a selector input (15), wherein the selector input (15) can be influenced during runtime of the FPGA code.

9. The method according to any one of the preceding claims, **characterized in that** the step of automatically inserting an influencing structure (11) comprises inserting an influencing structure (11) having a signal value able to be influenced during runtime.

10. The method according to the preceding claim 9, **characterized in that** the step of inserting an influencing structure (11) having a signal value able to be influenced during runtime comprises inserting an FPGA influencing component (17, 19, 21) and connecting the inserted FPGA influencing component (17, 19, 21) to the marked signal path (5).

11. The method according to any one of the preceding claims, **characterized in that** the method comprises the additional step of generating the FPGA model (1) as FPGA code, based on at least one part of the model as a release,
wherein the step of generating the FPGA model (1) as FPGA code as a release comprises generating the FPGA model without the influencing structure (11).

12. A data-processing device having a processor unit, wherein the data-processing device is implemented for performing the method according to any one of the claims 1 through 11.

13. A computer program product having computer-implemented instructions and executing the steps of the method according to any one of the claims 1 through 11 after loading and executing in a suitable data-processing device.

14. A digital storage medium having electronically readable control signals able to interact with a programmable data-processing device such that the method according to any one of the claims 1 through 11 is executed on the data-processing device.

## Revendications

1. Procédé pour contrôler le câblage externe des canaux E/S commandés par FPGA d'un simulateur HIL, dans lequel un outil de développeur (40) est relié avec un modèle de processeur (42) et, via ce dernier, avec un modèle FPGA (1), dans lequel un câble HIL interne (44) est reliée avec le modèle FPGA (1) via des ports E/S (54) du FPGA, qui réalise la liaison avec un connecteur de transfert (46), à la suite de quoi suit une liaison avec un faisceau de câbles externe (48) jusqu'à un appareil de commande (60), dans lequel l'appareil de commande (60) est relié avec un testeur de diagnostic (52) via un connecteur de diagnostic,
le procédé comprenant la création d'un code FPGA pour le modèle FPGA(1), la création d'un code FPGA comprenant les étapes suivantes ébaucher le modèle FPGA (1) en tant que programme FPGA avec au moins deux composantes (3) et au moins un trajet (5) de signal entre les au moins deux composantes (3),
définir un marquage (7) dans au moins un trajet (5) de signal dans le programme FPGA, et générer le modèle FPGA (1) en tant que code FPGA sur la base d'au moins une partie du modèle, sachant que l'étape de génération du modèle FPGA (1) en tant que code FPGA comprend l'insertion automatique d'une structure d'influence (11), laquelle peut lire et/ou modifier des valeurs de signal sur le trajet de signal, sur le trajet (5) de signal doté d'un marquage (7) et la création du modèle FPGA (1) avec la structure d'influence (11), sachant que l'étape d'insertion automatique d'une structure d'influence (11) comprend l'insertion d'un multiplexeur (13), qui peut être commuté pour la durée de fonctionnement pour fournir sur le trajet de signal marqué différents signaux d'entrée existant au multiplexeur,
le procédé comprenant en outre l'allocation de valeurs fixes pour les signaux existant au port E/S (54) d'un canal E/S commandé par FPGA via la structure d'influence (11) dans le modèle FPGA (1) et le contrôle de la conformité de la connexion de signal jusqu'au testeur de diagnostic (52).

2. Procédé selon la revendication 1, **caractérisé en ce que**
l'étape de définition d'un marquage (7) dans au moins un trajet (5) de signal dans le programme FPGA comprend la sélection d'une composante (3) du programme FPGA et la définition automatique de marquage (7) dans tous les trajets (5) de signaux de la composante (3) .

3. Procédé selon l'une des revendications 1 ou 2, **caractérisé en ce que**
l'étape de définition d'un marquage (7) dans au moins un trajet (5) de signal dans le programme FPGA comprend la sélection graphite d'une zone (9) du programme FPGA dans un outil de développeur graphique et la définition automatique de marquages (7) dans tous les trajets (5) de signaux dans la zone (9) de la sélection graphique.

4. Procédé selon l'une des revendications précédentes, **caractérisé en ce que** le procédé comprend, avant la génération du modèle FPGA (1), l'activation/la désactivation du marquage (7), et l'étape d'insertion automatique d'une structure d'influence (11) dans le trajet (5) de signal doté du marquage (7) comprend l'insertion automatique de la structure d'influence (11) pour les marquages actifs (7).

5. Procédé selon l'une des revendications précédentes, **caractérisé en ce que** le procédé comprend, avant la génération du modèle FPGA (1), la configuration du marquage (7), et
l'étape d'insertion automatique d'une structure d'influence (11) dans le trajet (5) de signal doté du marquage (7) comprend l'insertion de la structure d'influence (11) en fonction de sa configuration.

6. Procédé selon l'une des revendications précédentes, **caractérisé en ce que** l'étape d'insertion automatique d'une structure d'influence (11) comprend l'insertion d'une structure d'influence (11) en vue de la fourniture d'une valeur de signal alternative dans le trajet de signal (5) ou de la mutilation de la valeur de signal dans le trajet (5) de signal.

7. Procédé selon l'une des revendications précédentes, **caractérisé en ce que** l'étape d'insertion automatique d'une structure d'influence (11) comprend l'insertion d'une structure d'influence (11) en vue de la lecture d'une valeur de signal dans le trajet de signal (5).

8. Procédé selon l'une des revendications précédentes, **caractérisé en ce que** l'étape d'insertion d'un multiplexeur (13) comprend l'insertion d'un multiplexeur (13) avec entrée (15) de sélecteur, dans lequel l'entrée (15) de sélecteur peut être influencée pour la durée de fonctionnement du code FPGA.

9. Procédé selon l'une des revendications précédentes, **caractérisé en ce que** l'étape d'insertion automatique d'une structure d'influence (11) comprend l'insertion d'une structure d'influence (11) avec une valeur de signal pouvant être influencée pour la durée de fonctionnement.

10. Procédé selon la revendication 9 précédente, **caractérisé en ce que** l'étape d'insertion d'une structure d'influence (11) avec une valeur de signal pouvant être influencé pour la durée de fonctionnement comprend l'insertion d'une composante d'influence FPGA (17, 19, 21) et la mise en connexion de la composante d'influence FPGA (17, 19, 21) insérée avec le trajet (5) de signal marqué.

11. Procédé selon l'une des revendications précédentes, **caractérisé en ce que** le procédé comporte l'étape supplémentaire de création du modèle FPGA (1) en tant que code FPGA sur la base d'au moins une partie du modèle en tant que Release,
dans lequel l'étape de création du modèle FPGA (1) en tant que code FPGA en tant que Release comprend la création du modèle FPGA sans la structure d'influence (11).

12. Dispositif de traitement de données avec une unité de processeur, dans lequel le dispositif de traitement des données est réalisé pour exécuter le procédé selon l'une des revendications 1 à 11.

13. Produit de programme informatique avec des instructions implémentées sur ordinateur, qui, après le chargement et le lancement dans un dispositif de traitement de données approprié, exécute les étapes du procédé selon l'une des revendications 1 à 11.

14. Support de stockage numérique avec des signaux de commande lisibles électroniquement, qui peuvent coopérer avec un dispositif de traitement de données programmable de sorte que le procédé selon l'une des revendications 1 à 11 soit exécuté sur le dispositif de traitement de données.
